# EUROPEAN PATENT APPLICATION

(11) **EP 4 723 412 A1**
(43) Date of publication of application: **08.04.2026**
(21) Application number: 24905465.1
(22) Date of filing: 19.06.2024
(51) Int. Cl.: H02H 7/18

(54) **CONTROL CIRCUIT, CONTROL SYSTEM AND VEHICLE**

(30) Priority: 19.12.2023 CN 202323497238 U
(71) Applicant: Contemporary Amperex Technology Co., Limited, Ningde, Fujian 352100 (CN)
(72) Inventor: MA, Hang, Ningde, Fujian 352100 (CN); LI, Qiandeng, Ningde, Fujian 352100 (CN)
(74) Representative: Gong, Jinping
(86) International application number: PCT/CN2024/100215
(87) International publication number: WO 2025/129963

(57) **Abstract**

Disclosed in the present application are a control circuit, a control system, and a transportation device. The control circuit is configured to control connection or disconnection of a target loop after being connected to the target loop. The control circuit includes: a current detection unit, where the current detection unit is configured to: when being connected to a battery, output a first type signal when detecting that the battery has an overcurrent or a short circuit; and a driver circuit, where an input terminal of the driver circuit is connected to a signal output terminal of the current detection unit, an output terminal of the driver circuit is configured to connect to a safety module in the target loop, and the driver circuit is configured to output, in response to receiving the first type signal transmitted from the current detection unit, a drive signal to drive the safety module to be disconnected, where the target loop is a loop in the battery or a loop in a device in which the battery is located.

## Description

### CROSS REFERENCE

The present application claims priority to Chinese Patent Application No. 2023234972383, filed with the China National Intellectual Property Administration on December 19, 2023 and entitled "Control Circuit, Control System, and Transportation Device", which is incorporated herein by reference in its entirety.

### TECHNICAL FIELD

The present application relates to the field of vehicle technologies, and in particular, to a control circuit, a control system, and a transportation device.

### BACKGROUND

At present, a loop in a device needs to be disconnected in some cases to ensure stability of the device. For example, generally, when a vehicle undergoes a collision, a safety control module of the vehicle needs to calculate and determine severity of the collision by using signals sent by components such as an acceleration sensor and a peripheral sensor that are mounted in the vehicle, send a fourth type signal (squid) to each airbag at an appropriate time, and send a pulse width modulation signal with a specific change in a frequency or duty cycle to other control modules (such as a battery management module) of the vehicle at the same time, so that the other control modules send, after determining that the vehicle undergoes a collision, a second type signal to drive an active safety to be disconnected, thereby disconnecting a loop in which the active safety is located. However, a target loop of the device needs to be disconnected not only in a case that the device undergoes a collision, but also when a battery in the device is faulty. At present, however, there is no solution for this scheme.

### SUMMARY

Provided in the present application are at least a control circuit, a control system, and a transportation device.

Provided in the present application is a control circuit. The control circuit is configured to control connection or disconnection of a target loop after being connected to the target loop. The control circuit comprises: a current detection unit, wherein the current detection unit is configured to: when being connected to a battery, output a first type signal when detecting that the battery has an overcurrent or a short circuit; and a driver circuit, wherein an input terminal of the driver circuit is connected to a signal output terminal of the current detection unit, an output terminal of the driver circuit is configured to connect to a safety module in the target loop, and the driver circuit is configured to output, in response to receiving the first type signal transmitted from the current detection unit, a drive signal to drive the safety module to be disconnected, wherein the target loop is a loop in the battery or a loop in a device in which the battery is located.

In the above-mentioned solution, the current detection unit is disposed in the control circuit of the present application, and the current detection unit can detect whether the battery cooperating with the current detection unit has an overcurrent or a short circuit, so as to output the first type signal and send the first type signal to the driver circuit. The driver circuit can disconnect a safety module in a first target loop after receiving the first type signal, thereby achieving an effect of disconnecting the first target loop when the battery is problematic.

In some embodiments, another input terminal of the driver circuit is connected to a signal output terminal of an airbag system, wherein the driver circuit is further configured to output, in response to receiving a second type signal transmitted from the airbag system, the drive signal to drive the safety module to be disconnected.

In the above-mentioned solution, the another input terminal of the driver circuit is directly connected to the signal output terminal of the airbag system, so that the driver circuit can directly drive, after receiving the second type signal transmitted from the airbag system, the safety module to be disconnected, thereby achieving a purpose of disconnecting the target loop. Compared with the current situation that a battery management module needs to send a collision signal and then disconnect the target loop, this solution provides a higher speed of disconnecting the target loop.

In some embodiments, the control circuit comprises a supplementary driver circuit, an input terminal of the supplementary driver circuit is connected to the signal output terminal of the current detection unit, an output terminal of the supplementary driver circuit is configured to connect to a switch component in the target loop, and the supplementary driver circuit is configured to drive, in response to receiving the first type signal, the switch component to be disconnected.

In the above-mentioned solution, the supplementary driver circuit is disposed in the control circuit, so that after receiving the first type signal output by the current detection unit, the supplementary driver circuit can drive the switch component in the target loop to be disconnected, thereby achieving an effect of protecting the target loop.

In some embodiments, the switch component and the safety module are disposed on the same target loop, wherein the target loop comprises a power supply loop of the battery or a high-voltage loop of the device in which the battery is located; or the switch component and the safety module are respectively disposed on different target loops, wherein the safety module is disposed on a first target loop, the switch component is disposed on a second target loop, the first target loop comprises the power supply loop of the battery, and the second target loop comprises the high-voltage loop of the device in which the battery is located; or the first target loop comprises the high-voltage loop of the device in which the battery is located, and the second target loop comprises the power supply loop of the battery.

In the above-mentioned solution, in some application scenarios, the switch component and the safety module are disposed on the same target loop, so that one of the driver circuit and the supplementary driver circuit can control connection or disconnection of the target loop. If one of the driver circuit or the supplementary driver circuit is damaged, it can also be ensured that the other can control the target loop. In some application scenarios, the switch component and the safety module are disposed on different target loops, so that the driver circuit and the supplementary driver circuit can control connection or disconnection of different target loops. The target loop comprising the power supply loop of the battery can control connection or disconnection of the power supply loop of the battery, and the target loop comprising the high-voltage loop of the device in which the battery is located can control connection or disconnection of the high-voltage loop.

In some embodiments, the switch component comprises a relay, two path terminals of the relay are separately connected to the target loop to cooperate with other components on the target loop to form the complete target loop, a control terminal of the relay is connected to the output terminal of the supplementary driver circuit, the control circuit further comprises a delay circuit, and the delay circuit is disposed between the current detection unit and the supplementary driver circuit, wherein by means of the delay circuit, a time at which the first type signal generated by the current detection unit arrives at the driver circuit is earlier than a time at which the first type signal arrives at the supplementary driver circuit.

In the above-mentioned solution, the delay circuit is disposed in the control circuit, and the delay circuit is disposed between the current detection unit and the relay driver circuit, so that the time at which the first type signal output by the current detection unit arrives at the supplementary driver circuit can be delayed. This can ensure that the first type signal arrives at the driver circuit first, and then arrives at the supplementary driver circuit, thereby ensuring that the safety module in the target loop is disconnected before the relay, and achieving an effect of maintaining stability of the target loop in which the relay is located.

In some embodiments, another input terminal of the current detection unit is configured to connect to a battery management module, and the current detection unit is configured to send a fourth type signal when receiving a third type signal sent by the battery management module, wherein the driver circuit is further configured to output, in response to receiving the fourth type signal, a drive signal to drive the safety module to be disconnected.

In the above-mentioned solution, after being connected to the battery management module of the battery, the another input terminal of the current detection unit can generate the fourth type signal based on the third type signal sent by the battery management module, and the driver circuit disconnects the safety module in response to the fourth type signal, so that the safety module is disconnected more flexibly.

In some embodiments, the control circuit further comprises a logic component, an input terminal of the logic component is connected to the signal output terminal of the current detection unit, an output terminal of the logic component is connected to the driver circuit, and the logic component is turned on when a signal output by the current detection unit is the first type signal.

In the above-mentioned solution, the logic component is disposed in the control circuit, and the logic component is turned on when the signal output by the current detection unit is the first type signal, thereby reducing a case that a noise signal arrives at the driver circuit and consequently the safety module is mistakenly driven to be disconnected.

In some embodiments, the control circuit comprises an energy storage component, one terminal of the energy storage component charges the energy storage component when being connected to a power input apparatus, and the other terminal of the energy storage component is connected to the driver circuit and supplies power to the driver circuit.

In the above-mentioned solution, the energy storage component is disposed in the control circuit, and the energy storage component is used as a backup power supply component of the driver circuit, to provide a required voltage and current for the driver circuit, thereby improving reliability of the driver circuit, and further improving reliability of disconnecting the safety module.

In some embodiments, an input terminal of the current detection unit is connected to a shunt in the battery, so that a battery junction box detects a current flowing through the shunt to determine whether the battery has an overcurrent or a short circuit.

In the above-mentioned solution, after being connected to the shunt in the battery, the current detection unit can detect information such as a voltage and a current of the shunt, wherein the information such as the voltage or the current of the shunt can reflect whether the battery has an overcurrent or a short circuit, so as to determine, based on the detected information, whether the battery has an overcurrent or a short circuit, thereby simplifying a process of detecting the overcurrent or the short circuit of the battery.

In some embodiments, the current detection unit comprises a current collection circuit, a comparator, and a reference current output device; a collection terminal of the current collection circuit is connected to the shunt; and two input terminals of the comparator are respectively connected to an output terminal of the current collection circuit and an output terminal of the reference current output device, so that the comparator outputs the first type signal when detecting that a current value output by the current collection circuit is greater than or equal to a reference current value output by the reference current output device.

In the above-mentioned solution, the current collection circuit is disposed in the current detection unit, so that a current of the shunt in the battery can be collected, and then the comparator compares a current value of the shunt with the reference current value, thereby determining whether the battery has an overcurrent or an overvoltage.

In some embodiments, the output terminal of the driver circuit is further configured to connect to a relay in the target loop.

In the above-mentioned solution, when the output terminal of the driver circuit is connected to the relay in the first target loop, the relay can be further driven for connection or disconnection through the relay.

In some embodiments, the input terminal of the driver circuit is configured to connect to the battery management module, the battery management module is configured to input a fifth type signal to the driver circuit, and the driver circuit outputs, when receiving the fifth type signal, a drive signal to drive the safety module to be disconnected.

In the above-mentioned solution, a plurality of manners of driving the safety module to be disconnected are provided, so that when some driving manners are problematic, the safety module can still be driven to be disconnected.

In some embodiments, the driver circuit comprises a direct driver circuit, an isolation driver circuit, or a dedicated integrated driver chip.

In the above-mentioned solution, the driver circuit is disposed so that the first type signal can be adjusted to a signal that can drive the safety module to be disconnected.

In some embodiments, the driver circuit comprises a gate resistor, a pull-down resistor, a logic level switching transistor, and a regulating resistor; an input terminal of the gate resistor is connected to an output terminal of the current detection unit; an input terminal of the pull-down resistor is connected to an output terminal of the gate resistor, and an output terminal of the pull-down resistor is grounded; and a first terminal of the logic level switching transistor is connected to the output terminal of the gate resistor, a second terminal of the logic level switching transistor is grounded, a third terminal of the logic level switching transistor is connected to an input terminal of the regulating resistor, and an output terminal of the regulating resistor is connected to the safety module.

In the above-mentioned solution, the driver circuit can amplify the input signal so that the safety module can be driven.

Provided in the present application is a control system. The control system comprises a battery and the control circuit in any one of the above-mentioned embodiments. The control circuit is configured to control connection or disconnection of a target loop after being connected to the target loop. The control circuit comprises a current detection unit and a driver circuit. The current detection unit is configured to: when being connected to the battery, output a first type signal when detecting that the battery has an overcurrent or a short circuit. An input terminal of the driver circuit is connected to a signal output terminal of the current detection unit, an output terminal of the driver circuit is connected to a safety module in the target loop, and the driver circuit is configured to output, in response to receiving the first type signal transmitted from the current detection unit, a drive signal to drive the safety module to be disconnected. The target loop is a loop in the battery or a loop in a device in which the battery is located.

In the above-mentioned solution, the current detection unit is disposed in the control circuit in this solution, and the current detection unit can detect whether the battery cooperating with the current detection unit has an overcurrent or a short circuit, so as to output the first type signal and send the first type signal to the driver circuit. The driver circuit can disconnect a safety module in a first target loop after receiving the first type signal, thereby achieving an effect of disconnecting the first target loop when the battery is problematic.

In some embodiments, the control system further comprises an airbag system, the input terminal of the driver circuit is connected to a signal output terminal of the airbag system, the airbag system is configured to output a second type signal from the signal output terminal when detecting that the device in which the battery is located undergoes a collision, and the driver circuit is further configured to output, in response to receiving the second type signal transmitted from the airbag system, the drive signal to drive the safety module to be disconnected.

In the above-mentioned solution, the input terminal of the driver circuit is directly connected to the signal output terminal of the airbag system, so that the driver circuit can directly drive, after receiving the second type signal transmitted from the airbag system, the safety module to be disconnected, thereby achieving a purpose of disconnecting the target loop. Compared with the current situation that a battery management module needs to send a collision signal and then disconnect the target loop, this solution provides a higher speed of disconnecting the target loop.

In some embodiments, the airbag system comprises an airbag control unit and an energy storage unit, the energy storage unit is configured to provide power for the airbag control unit, and the airbag control unit is configured to output the second type signal when detecting that a device in which the airbag control unit is located undergoes a collision.

In the above-mentioned solution, the energy storage unit is disposed, so that the energy storage unit can be used for the airbag control unit, thereby improving reliability of generating the fourth type signal by the airbag control unit.

In some embodiments, the airbag system comprises an impedance detection unit and a prompt unit; two collection terminals of the impedance detection unit are connected to a signal output terminal of the airbag control unit and the safety module, an output terminal of the impedance detection unit is connected to the airbag control unit, and the impedance detection unit is configured to send detected impedance between the signal output terminal of the airbag control unit and the safety module to the airbag control unit; and an input terminal of the prompt unit is connected to the airbag control unit, the airbag control unit is configured to send prompt information to the prompt unit in response to the impedance being greater than or equal to preset impedance, and the prompt unit performs a preset prompt action after receiving the prompt information.

In the above-mentioned solution, the impedance detection unit and the prompt unit are disposed in the airbag system, so that when it is detected that the fourth type signal possibly cannot be transmitted to the safety module due to the large impedance between the signal output terminal of the airbag control unit and the safety module, the prompt unit can be sent, which is convenient for a user to take a countermeasure in a timely manner, so that the fourth type signal can be transmitted to the safety module when a transportation device in which the control circuit is located undergoes a collision.

In some embodiments, the control system comprises a battery management module, one terminal of the battery management module is connected to the battery, and an output terminal of the battery management module is connected to the current detection unit or the driver circuit.

In the above-mentioned solution, a plurality of manners of driving the safety module to be disconnected are provided, so that when some driving manners are problematic, the safety module can still be driven to be disconnected.

Provided in the present application is a transportation device. The transportation device comprises the control circuit in any one of the above-mentioned embodiments.

In the above-mentioned solution, the current detection unit is disposed in the control circuit of the present application, and the current detection unit can detect whether the battery cooperating with the current detection unit has an overcurrent or a short circuit, so as to output the first type signal and send the first type signal to the driver circuit. The driver circuit can disconnect a safety module in a first target loop after receiving the first type signal, thereby achieving an effect of disconnecting the first target loop when the battery is problematic.

It should be understood that the above-mentioned general description and the following detailed description are only exemplary and explanatory, and do not limit the present application.

### DESCRIPTION OF DRAWINGS

The accompanying drawings herein are incorporated into the specification and constitute a part of the specification, and these accompanying drawings show embodiments consistent with the present application and are used together with the specification to illustrate the technical solutions of the present application.
FIG. 1 is a schematic structural diagram of a control circuit according to some embodiments;
FIG. 2 is a schematic structural diagram of a current detection unit according to some embodiments;
FIG. 3 is a schematic structural diagram of a driver circuit according to some embodiments;
FIG. 4 is a schematic structural diagram of a control system according to some embodiments; and
FIG. 5 is a schematic structural diagram of a transportation device according to some embodiments.

### Reference signs:

1 - transportation device; 10 - control system; 100 - control circuit; 200 - airbag system; 300 - power input apparatus; 400 - battery; 500 - battery management module; 110 - current detection unit; 120 - driver circuit; 130 - supplementary driver circuit; 140 - delay circuit; 150 - logic component; 160 - energy storage component; 210 - airbag control unit; 220 - energy storage unit; 230 - impedance detection unit; 240 - prompt unit; 410 - target loop; 420 - safety module; 430 - switch component; 440 - shunt; 111 - current collection current; 112 - comparator; 113 - reference current output device; 121 - gate resistor; 122 - pull-down resistor; 123 - logic level switching transistor; 124 - regulating resistor.

### DESCRIPTION OF EMBODIMENTS

The following describes solutions in embodiments of the present application in detail with reference to accompanying drawings of the specification.

In the following description, for the purpose of illustration rather than limitation, specific details such as specific subsystem structures, interfaces, and techniques are proposed to facilitate a thorough understanding of the present application.

The term "and/or" in the specification is only an associative relationship for describing associated objects, indicating that three relationships may be present. For example, A and/or B may indicate three cases: presence of only A; presence of both A and B; and presence of only B. In addition, the character "/" herein generally indicates that associated objects are in a "or" relationship. In addition, "a plurality of" in the specification means two or more than two. In addition, the term "at least one" in the specification means any one of a plurality of pieces, or any combination of at least two of a plurality of pieces. For example, including at least one of A, B, and C may mean including any one or a plurality of elements selected from a set consisting of A, B, and C.

Considering that a target loop of the device needs to be disconnected not only in a case that the device undergoes a collision, but also when a battery in the device is faulty, however, there is no solution for this scheme at present. Further considering that if the battery is faulty, and a loop in the battery or a high-voltage loop in a device in which the battery is located or the like is not disconnected, it is likely to cause the battery to explode or cause the high-voltage loop to be damaged, and so on, based on this, the present application provides a control circuit. A current detection unit is disposed to detect whether the battery has an overcurrent or a short circuit. If the battery has an overcurrent or a short circuit, the current detection unit can output a first type signal, so that the driver circuit drives, based on the signal, a safety module in a first target loop to be disconnected.

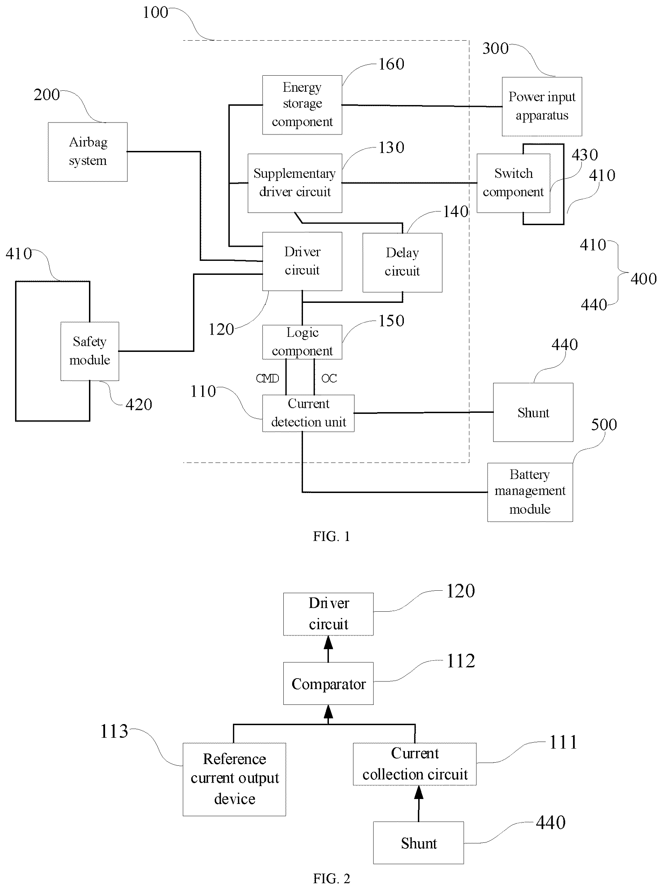

Referring to FIG. 1, a control circuit 100 provided in an embodiment of the present application is configured to control connection or disconnection of a target loop after being connected to the target loop, and the control circuit includes a current detection unit 110 and a driver circuit 120. The current detection unit 110 is configured to: when being connected to a battery 400, output a first type signal OC when detecting that the battery 400 has an overcurrent or a short circuit. An input terminal of the driver circuit 120 is connected to a signal output terminal of the current detection unit 110, an output terminal of the driver circuit 120 is configured to connect to a safety module 420 in the target loop 410, and the driver circuit 120 is configured to output, in response to receiving the first type signal transmitted from the current detection unit 110, a drive signal to drive the safety module 420 to be disconnected, where the target loop 410 is a loop in the battery 400 or a loop in a device in which the battery 400 is located.

The current detection unit 110 can be configured to detect whether the battery 400 has an overcurrent or a short circuit. The current detection unit 110 may be a battery junction box, or another circuit capable of performing overcurrent detection. The battery 400 may be a battery pack. For example, the battery 400 may be a power battery, and the battery pack may include one or a plurality of battery cells. The overcurrent may be understood as that an output current of the battery 400 goes beyond a normal range. A manner of determining an overcurrent or a short circuit of the battery 400 may be setting two current thresholds of different magnitudes, namely, a first current threshold and a second current threshold, where both the first current threshold and the second current threshold are greater than a normal current value, and the first current threshold is less than the second current threshold. When a detected current value is greater than the first current threshold and less than the second current threshold, it is determined that the battery 400 has an overcurrent. When the detected current value is greater than or equal to the second current threshold, it is determined that the battery 400 has a short circuit. A specific structure of the current detection unit 110 is not specifically limited herein, provided that the overcurrent and the short circuit of the battery 400 can be detected and the corresponding first type signal OC can be output. The driver circuit 120 is a driver circuit 120 that drives the safety module 420 to be disconnected. Generally, the first type signal is a PWM signal, and the driver circuit 120 can perform power amplification on the PWM signal to drive connection or disconnection of the safety module 420. The driver circuit 120 includes, but is not limited to, a directly grounded driver circuit, a floating ground driver, an isolation driver, a non-isolation driver, and the like. After receiving the first type signal, the driver circuit 120 can perform power amplification on the signal and then output the signal to the safety module 420, thereby driving the safety module 420 to be disconnected, and achieving a purpose of protecting other components in the target loop. The safety module 420 may be an active safety or an electrical switch. For example, the electrical switch may be an electrical switch with strong tensile arc resistance, such as a circuit breaker. In FIG. 1, the target loop 410 is the loop in the battery 400. The target loop 410 being the loop in the device in which the battery 400 is located is not shown in the figure.

In the above-mentioned solution, the current detection unit 110 is disposed in the control circuit 100 of this solution, and the current detection unit 110 can detect whether the battery 400 cooperating with the current detection unit has an overcurrent or a short circuit, so as to output the first type signal OC and send the first type signal to the driver circuit 120. The driver circuit 120 can disconnect the safety module 420 in the target loop after receiving the first type signal OC. This solution takes into account both the collision situation and the overcurrent situation, and can achieve a purpose of disconnecting the target loop 410 in a plurality of situations, thereby improving reliability of disconnecting the target loop 410.

In some embodiments, another input terminal of the driver circuit 120 is connected to a signal output terminal of an airbag system 200, and the driver circuit 120 is further configured to output, in response to receiving a second type signal transmitted from the airbag system 200, the drive signal to drive the safety module 420 to be disconnected.

The airbag system 200 may generate the second type signal when detecting that the device in which the control circuit 100 is located undergoes a collision. The second type signal may drive an airbag within the device to open. Generally, the second type signal is a PWM signal, and the driver circuit 120 can perform power amplification on the PWM signal to drive connection or disconnection of the safety module 420. The driver circuit 120 may have a plurality of input terminals, one input terminal of which is connected to the signal output terminal of the airbag system 200, and another input terminal of which is connected to the signal output terminal of the current detection unit 110. After receiving the first type signal or the second type signal, the driver circuit 120 can perform power amplification on the signal and then output the signal to the safety module 420, thereby driving the safety module 420 to be disconnected, and achieving a purpose of protecting other components in the target loop 410.

In the above-mentioned solution, the input terminal of the driver circuit 120 is directly connected to the signal output terminal of the airbag system 200, so that the driver circuit 120 can directly drive, after receiving the second type signal transmitted from the airbag system, the safety module 420 to be disconnected, thereby achieving a purpose of disconnecting the target loop 410. Compared with the current situation that a battery management module 500 needs to send a collision signal and then disconnect the target loop, this solution provides a higher speed of disconnecting the target loop.

In some embodiments, the control circuit 100 includes a supplementary driver circuit 130. An input terminal of the supplementary driver circuit 130 is connected to the signal output terminal of the current detection unit 110, an output terminal of the supplementary driver circuit 130 is configured to connect to a switch component 430 in the target loop 410, and the supplementary driver circuit 130 is configured to drive, in response to receiving the first type signal, the switch component 430 to be disconnected.

The target loop 410 in which the safety module 420 is located and the target loop 410 in which the switch component 430 is located may be the same target loop, or may be different target loops. For example, the target loop 410 in which the safety module 420 is located and the target loop 410 in which the switch component 430 is located are the same loop, and the loop may be a power supply loop in the battery 400 or a high-voltage loop in the device in which the battery 400 is located. Alternatively, one loop of the target loop 410 in which the safety module 420 is located and the target loop 410 in which the switch component 430 is located is a power supply loop, and the other loop is a high-voltage loop or the like. The high-voltage loop may be an ignition loop or the like. A specific structure of the high-voltage loop is not the focus of this solution, and the high-voltage loop is not specifically limited herein. One terminal of the power supply loop is connected to a positive electrode of the battery 400, and the other terminal of the power supply loop is connected to a negative electrode of the battery 400. The switch component 430 may be an electrical switch, a safety module 420, a relay, or the like. The supplementary driver circuit 130 is a driver circuit 120 that can drive the switch component 430 to be disconnected, and a structure of the supplementary driver circuit 130 may be the same as or different from the structure of the driver circuit 120 described above. The supplementary driver circuit 130 is also a driver circuit 120. The driver circuit 120 includes, but is not limited to, a directly grounded driver circuit 120, a floating ground driver, an isolation driver, a non-isolation driver, and the like. The input terminal of the supplementary driver circuit 130 is connected to the signal output terminal of the current detection unit 110, so that the supplementary driver circuit 130 can receive the first type signal OC output by the current detection unit 110, and the supplementary driver circuit 130 can perform power amplification on the first type signal OC. In this way, the first type signal OC after the power amplification can drive the switch component 430 to be disconnected, thereby achieving an effect of the target loop 410.

In the above-mentioned solution, the supplementary driver circuit 130 is disposed in the control circuit 100, so that after receiving the first type signal output by the current detection unit 110, the supplementary driver circuit 130 can drive the relay in the battery 400 to be disconnected, thereby achieving an effect of protecting the battery 400.

In some embodiments, the switch component 430 and the safety module 420 are disposed on the same target loop 410, where the target loop 410 includes a power supply loop of the battery 400 or a high-voltage loop of the device in which the battery 400 is located. Alternatively, the switch component 430 and the safety module 420 are respectively disposed on different target loops 410, where the safety module 420 is disposed on a first target loop, the switch component 430 is disposed on a second target loop, the first target loop includes the power supply loop of the battery 400, and the second target loop includes the high-voltage loop of the device in which the battery 400 is located; or the first target loop includes the high-voltage loop of the device in which the battery 400 is located, and the second target loop includes the power supply loop of the battery 400.

In some application scenarios, the switch component 430 and the safety module 420 are disposed on the same target loop 410, where the target loop 410 includes a power supply loop of the battery 400 or a high-voltage loop of the device in which the battery 400 is located. In some application scenarios, the switch component 430 and the safety module 420 are respectively disposed on different target loops 410, where the safety module 420 is disposed on a first target loop, the switch component 430 is disposed on a second target loop, the first target loop includes the power supply loop of the battery 400, and the second target loop includes the high-voltage loop of the device in which the battery 400 is located. In some application scenarios, the switch component 430 and the safety module 420 are respectively disposed on different target loops 410, where the safety module 420 is disposed on a first target loop, the switch component 430 is disposed on a second target loop, the first target loop includes the high-voltage loop of the device in which the battery 400 is located, and the second target loop includes the power supply loop of the battery 400.

In the above-mentioned solution, in some application scenarios, the switch component 430 and the safety module 420 are disposed on the same target loop, so that one of the driver circuit 120 and the supplementary driver circuit 130 can control connection or disconnection of the target loop 410. If one of the driver circuit 120 or the supplementary driver circuit 130 is damaged, it can also be ensured that the other can control the target loop 410. In some application scenarios, the switch component 430 and the safety module 420 are disposed on different target loops 410, so that the driver circuit 120 and the supplementary driver circuit 130 can control connection or disconnection of different target loops 410. The target loop 410 including the power supply loop of the battery 400 can control connection or disconnection of the power supply loop of the battery 400, and the target loop 410 including the high-voltage loop of the device in which the battery 400 is located can control connection or disconnection of the high-voltage loop.

In some embodiments, the switch component 430 includes a relay (not shown in the figure). Two path terminals of the relay are separately connected to the target loop 410 to cooperate with other components (not shown in the figure) on the target loop 410 to form the complete target loop 410, a control terminal of the relay is connected to the output terminal of the supplementary driver circuit 130, the control circuit 100 further includes a delay circuit 140, and the delay circuit 140 is disposed between the current detection unit 110 and the supplementary driver circuit 130, where by means of the delay circuit 130, a time at which the first type signal generated by the current detection unit 110 arrives at the driver circuit 120 is earlier than a time at which the first type signal arrives at the supplementary driver circuit 130.

The delay circuit 140 includes, but is not limited to, an RC delay circuit, a simple long delay circuit, a long delay circuit that includes two 555 time-base circuits, a monostable delay circuit that includes a single operational amplifier, a transistor delay circuit, and the like. In this solution, the RC delay circuit is used as an example, and delay duration of the circuit may be adjusted by using a value of R or C. The delay circuit 140 is disposed in the control circuit 100, so as to ensure that the first type signal OC output by the current detection unit 110 arrives at the driver circuit 120 first and then arrives at the supplementary driver circuit 130, so that the safety module 420 is disconnected before the relay. The target loop in which the relay is located may be a power supply loop in the battery 400, and the power supply loop may supply power to a load connected to the battery 400, or charge the battery 400. The battery 400 may be a battery pack, and the relay may be a main positive relay, a main secondary relay, another relay, or the like in the battery. For example, single battery cells are packed based on a specific quantity of series-parallel connections, typically in a combination of 4 strings, 6 strings, 10 strings, 12 strings, and the like, and modules are cascaded in series to obtain the battery 400 in this solution. The main positive relay is placed on a positive electrode of the battery 400, and disconnecting the relay means disconnecting an external output of the battery. The main secondary relay is disposed on a negative electrode of the battery. When the device such as a vehicle is not in use, both the main secondary relay and the main positive relay are disconnected, ensuring that the high-voltage battery is completely insulated from the outside.

In the above-mentioned solution, the delay circuit 140 is disposed in the control circuit 100, and the delay circuit 140 is disposed between the current detection unit 110 and the supplementary driver circuit 130, so that the time at which the first type signal output by the current detection unit 110 arrives at the supplementary driver circuit 130 can be delayed. This can ensure that the first type signal arrives at the driver circuit 120 first, and then arrives at the supplementary driver circuit 130, thereby ensuring that the target loop 410 in which the safety module 420 is located is disconnected before the target loop 410 in which the relay is located. When the target loop in which the relay is located may be the power supply loop in the battery 400, a risk of explosion of the battery 400 caused by disconnecting the relay first and then disconnecting the safety module 420 can be reduced.

In some embodiments, an input terminal of the current detection unit 110 is connected to a shunt 440 in the battery 400, so that the current detection unit 110 detects a current flowing through the shunt 440 to determine whether the battery 400 has an overcurrent or a short circuit.

The current detection unit 110 may be a battery junction box (BJB), and the battery junction box generally has the following functions: high voltage detection, current sampling, temperature detection, and insulation detection. A target electrode may be the positive electrode or the negative electrode. Optionally, the battery 400 may be a battery pack, the battery 400 includes a plurality of battery cells (not shown in the figure), and the shunt may be connected in parallel to the battery cells, or be disposed on a bus connected to the battery cells, and so on. A disposing position of the shunt is not specifically limited herein. Optionally, single battery cells are packed based on a specific quantity of series-parallel connections, typically in a combination of 4 strings, 6 strings, 10 strings, 12 strings, and the like, and modules are cascaded in series to obtain the battery 400 in this solution. At present, a large quantity of ternary lithium batteries are used on the market, for which a capacity and a volume are larger, a quantity of parallel connections is basically 1, and there is also a solution of 4 strings for a quantity of strings of the module at present. This better facilitates arrangement and capacity matching for the module in the battery pack. In some embodiments, the target loop 410 is a charging loop in the battery 400, and the safety module 420 may be disposed between two battery modules to connect the two battery modules.

In the above-mentioned solution, after being connected to the shunt 440 in the battery 400, the current detection unit 110 can detect information such as a voltage and a current of the shunt 440, where the information such as the voltage or the current of the shunt 440 can reflect whether the battery 400 has an overcurrent or a short circuit, so as to determine, based on the detected information, whether the battery 400 has an overcurrent or a short circuit, thereby simplifying a process of detecting the overcurrent or the short circuit of the battery 400.

Referring to FIG. 2, in some embodiments, the current detection unit 110 includes a current collection circuit 111, a comparator 112, and a reference current output device 113. A collection terminal of the current collection circuit 111 is connected to the shunt 440, and two input terminals of the comparator 112 are respectively connected to an output terminal of the current collection circuit 111 and an output terminal of the reference current output device 113, so that the comparator 112 outputs the first type signal when detecting that a current value output by the current collection circuit 111 is greater than or equal to a reference current value output by the reference current output device 113.

The current collection circuit may be an analog to digital converter (ADC) circuit, and the ADC is mainly configured to perform digital collection on an analog signal for data processing. A data collection terminal of the ADC circuit is connected to two terminals of the shunt 440 in the battery 400. A voltage drop is generated when a current flows through the shunt 440, and then the current flowing through the shunt is determined by using a voltage differential signal. The comparator 112 may be an operational amplifier. The reference current output device 113 may be a chip or a circuit capable of outputting a preset current value.

In the above-mentioned solution, the current collection circuit is disposed in the current detection unit, so that a current of the shunt in the battery can be collected, and then the comparator compares the current of the shunt with the reference current, thereby determining whether the battery has an overcurrent or an overvoltage.

In some embodiments, another input terminal of the current detection unit 110 is configured to connect to a battery management module 500, and the current detection unit is configured to send a fourth type signal CMD when receiving a third type signal sent by the battery management module, where the driver circuit is further configured to output, in response to receiving the fourth type signal CMD, a drive signal to drive the safety module to be disconnected.

The battery management module 500 is a battery management unit (BMU). After receiving the third type signal from the BMU/another controller, the current detection unit 110 may drive the safety module 420 and the above-mentioned relay to be disconnected. The third type signal may be a digital signal. The current detection unit 110 can generate the fourth type signal CMD after receiving the third type signal, and then the fourth type signal CMD can be sent to the driver circuit 120 and the supplementary driver circuit 130, so that the driver circuit 120 and the supplementary driver circuit 130 can drive the corresponding safety module 420 and relay to be disconnected.

In the above-mentioned solution, after being connected to the battery management module 500 of the battery 400, the another input terminal of the current detection unit 110 can generate the fourth type signal CMD based on the signal sent by the battery management module 500 to disconnect the safety module 420, so that the safety module 420 is disconnected more flexibly.

In some embodiments, the control circuit 100 further includes a logic component 150, an input terminal of the logic component 150 is connected to the signal output terminal of the current detection unit 110, an output terminal of the logic component 150 is connected to the driver circuit 120, and the logic component is turned on when a signal output by the current detection unit 110 is the first type signal.

The logic component 150 may be an OR gate or another logic gate circuit. In this embodiment, for example, the logic component 150 is an OR gate. The signal output by the current detection unit 110 may be the signal received from the current detection unit 110, which is the first type signal OC or the fourth type signal CMD. In some other embodiments, an output terminal of the logic component 150 is connected to the driver circuit 120, and the logic component may be further turned on when a signal output by the current detection unit 110 is the fourth type signal.

In the above-mentioned solution, the logic component 150 is disposed in the control circuit 100, and the logic component can be turned on when the signal output by the current detection unit 110 is the first type signal, thereby reducing a case that a noise signal arrives at the driver circuit 120 and consequently the safety module 420 is mistakenly driven to be disconnected.

In some embodiments, the control circuit 100 includes an energy storage component 160, one terminal of the energy storage component 160 charges the energy storage component 160 when being connected to a power input apparatus 300, and the other terminal of the energy storage component 160 is connected to the driver circuit 120 and supplies power to the driver circuit 120.

One terminal of the energy storage component 160 may be further connected to the supplementary driver circuit 130 to supply power to the supplementary driver circuit 130. The power input apparatus 300 may be charged by a 12V direct current of the entire vehicle or by the battery 400. Optionally, the control circuit 100 may be integrated on a control board, and a power supply port is provided on the control board. One terminal of the power supply port is connected to the energy storage component 160, and the other terminal of the power supply port is configured to connect to the power input apparatus 300.

In the above-mentioned solution, the energy storage component 160 is disposed in the control circuit 100, and the energy storage component 160 is used as a backup power supply component of the driver circuit 120, to provide a required voltage and current for the driver circuit 120, thereby improving reliability of the driver circuit 120, and further improving reliability of disconnecting the safety module 420.

In some embodiments, the output terminal of the driver circuit 120 is further configured to connect to a relay in the target loop 410.

To be specific, the driver circuit 120 may have two output terminals. One output terminal is connected to the safety module 420 in the target loop 410, and the other output terminal is connected to the relay in the target loop 410. After receiving the first type signal or the fourth type signal, the driver circuit 120 can drive the relay and the safety module 420 to be disconnected. In some application scenarios, the target loop 410 is a power supply loop in the battery 400, and the relay may be a main positive relay, a main negative relay, another relay, or the like.

In the above-mentioned solution, when the output terminal of the driver circuit 120 is connected to the relay in the target loop 410, the relay can be further driven for connection or disconnection through the relay.

In some embodiments, the input terminal of the driver circuit 120 is configured to connect to the battery management module 500, the battery management module 500 is configured to input a fifth type signal to the driver circuit 120, and the driver circuit 120 outputs, when receiving the fifth type signal, a drive signal to drive the safety module 420 to be disconnected.

The fifth type signal may also be a digital signal. For example, the battery management module 500 may send a preset fifth type signal when detecting that the target loop 410 needs to be disconnected, so that the driver circuit 120 can drive the target loop 410 to be disconnected.

In the above-mentioned solution, a plurality of manners of driving the safety module 420 to be disconnected are provided, so that when some driving manners are problematic, the safety module 420 can still be driven to be disconnected.

In some embodiments, the driver circuit 120 is a direct driver circuit, an isolation driver circuit, or a dedicated integrated driver chip.

The direct driver circuit is a driver circuit formed by connecting single electronic components (such as a diode, a triode, a resistor, and a capacitor). The circuit does not have electrical isolation, and is mostly used in a low-power driving occasion with a simple function. The isolation driver circuit includes an isolation component, which includes optocoupler driving, transformer driving, isolation capacitor driving, and the like that are commonly used. Based on a quantity of power components controlled by the driver chip, the driver chip may be classified into a single-driver chip and a double-driver chip.

In the above-mentioned solution, the driver circuit 120 is disposed so that the first type signal can be adjusted to a signal that can drive the safety module 420 to be disconnected.

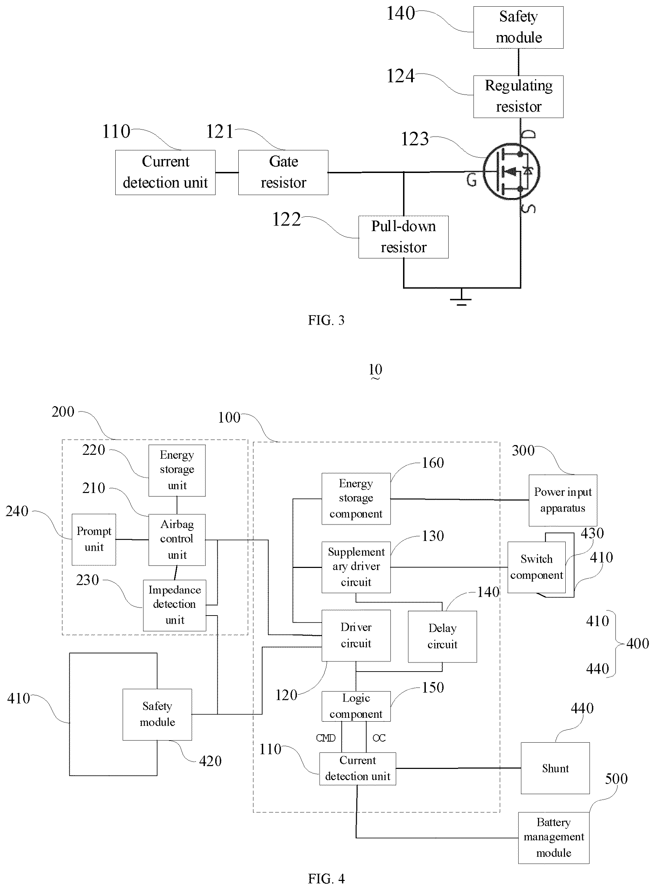

Referring to FIG. 3, in some embodiments, the driver circuit 120 includes a gate resistor 121, a pull-down resistor 122, a logic level switching transistor 123, and a regulating resistor 124. An input terminal of the gate resistor 121 is connected to an output terminal of the current detection unit 110. An input terminal of the pull-down resistor 122 is connected to an output terminal of the gate resistor 121, and an output terminal of the pull-down resistor 122 is grounded. A first terminal of the logic level switching transistor 123 is connected to the output terminal of the gate resistor 121, a second terminal of the logic level switching transistor 123 is grounded, a third terminal of the logic level switching transistor 123 is connected to an input terminal of the regulating resistor 124, and an output terminal of the regulating resistor 124 is connected to the safety module.

The logic level switching transistor 123 may be a logic level MOS transistor, and a specific category and type are not limited. The logic level MOS transistor is used herein as an example for description. An input terminal of the gate resistor 121 is connected to an output terminal of the current detection unit. An input terminal of the pull-down resistor 122 is connected to an output terminal of the gate resistor 121, and an output terminal of the pull-down resistor 122 is grounded. G of the logic level MOS transistor is connected to the output terminal of the gate resistor 121, an S terminal of the logic level MOS transistor is grounded, a D terminal of the logic level MOS transistor is connected to an input terminal of the regulating resistor 124, and an output terminal of the regulating resistor 124 is connected to the safety module. When the logic level switching transistor is a high-power switching transistor or any low-speed circuit, an exact value of the gate resistor 121 is generally not important. A 10R or 100R resistor is generally used and adjusted as needed during testing. The gate resistor 121 and the pull-down resistor 122 are generally used in cooperation. Placing the gate resistor 121 to the left of the pull-down resistor 122 results in a voltage divider circuit, which lowers a voltage at the gate. In some other embodiments, the pull-down resistor 122 may also be disposed on the left side of the gate resistor 121. A resistance relationship among the gate resistor 121, the pull-down resistor 122, and the regulating resistor 124 may be set based on a requirement of the driver circuit 120, which is not specifically limited herein.

In the above-mentioned solution, the driver circuit 120 can amplify the input signal so that the safety module can be driven.

Referring to FIG. 4 together, as shown in FIG. 4, the control system 10 provided in this solution includes a battery 400 and the control circuit 100 in any one of the above-mentioned embodiments. The control circuit 100 is configured to control connection or disconnection of a target loop 410 after being connected to the target loop. The control circuit 100 includes a current detection unit 110 and a driver circuit 120. The current detection unit 110 is configured to: when being connected to the battery 400, output a first type signal OC when detecting that the battery 400 has an overcurrent or a short circuit. An input terminal of the driver circuit 120 is connected to a signal output terminal of the current detection unit 110, an output terminal of the driver circuit 120 is configured to connect to a safety module 420 in the target loop 410, and the driver circuit 120 is configured to output, in response to receiving the first type signal transmitted from the current detection unit 110, a drive signal to drive the safety module 420 to be disconnected. The target loop 410 is a loop in the battery 400 or a loop in a device in which the battery 400 is located.

The current detection unit 110 can be configured to detect whether the battery 400 has an overcurrent or a short circuit. The battery 400 may be a battery pack. For example, the battery 400 may be a power battery, and the battery pack may include one or a plurality of battery cells. The overcurrent may be understood as that an output current of the battery 400 goes beyond a normal range. A manner of determining an overcurrent or a short circuit of the battery 400 may be setting two current thresholds of different magnitudes, namely, a first current threshold and a second current threshold, where both the first current threshold and the second current threshold are greater than a normal current value, and the first current threshold is less than the second current threshold. When a detected current value is greater than the first current threshold and less than the second current threshold, it is determined that the battery 400 has an overcurrent. When the detected current value is greater than or equal to the second current threshold, it is determined that the battery 400 has a short circuit. A specific structure of the current detection unit 110 is not specifically limited herein, provided that the overcurrent and the short circuit of the battery 400 can be detected and the corresponding first type signal OC can be output. The driver circuit 120 is a driver circuit 120 that drives the safety module 420 to be disconnected. Generally, the fourth type signal and the first type signal are PWM signals, and the driver circuit 120 can perform power amplification on the PWM signal to drive connection or disconnection of the safety module 420. The driver circuit 120 includes, but is not limited to, a directly grounded driver circuit, a floating ground driver, an isolation driver, a non-isolation driver, and the like. There may alternatively be two input terminals of the driver circuit 120, one input terminal of which is connected to the signal output terminal of the airbag system 200, and the other input terminal of which is connected to the signal output terminal of the current detection unit 110. After receiving the first type signal or the fourth type signal, the driver circuit 120 can perform power amplification on the signal and then output the signal to the safety module 420, thereby driving the safety module 420 to be disconnected, and achieving a purpose of protecting other components in the target loop. The safety module 420 may be a safety module 420 or an electrical switch. For example, the electrical switch may be an electrical switch with strong tensile arc resistance, such as a circuit breaker.

In the above-mentioned solution, the input terminal of the driver circuit 120 is directly connected to a signal output terminal of an airbag, so that the driver circuit 120 can directly drive, after receiving the second type signal transmitted from the airbag system, the safety module 420 to be disconnected, thereby achieving a purpose of disconnecting the target loop. Compared with the current situation that the battery 400 system needs to send a collision signal and then disconnect the target loop, this solution provides a higher speed of disconnecting the target loop. In addition, the current detection unit 110 is further disposed in the control circuit 100 of this solution, and the current detection unit 110 can detect whether the battery 400 cooperating with the current detection unit has an overcurrent or a short circuit, so as to output the first type signal OC and send the first type signal to the driver circuit 120. The driver circuit 120 can still disconnect the safety module 420 in the target loop 410 after receiving the first type signal OC. This solution takes into account both the collision situation and the overcurrent situation, and can achieve a purpose of disconnecting the target loop in a plurality of situations, thereby improving reliability of disconnecting the target loop.

In some embodiments, the control system 10 further includes an airbag system 200, the input terminal of the driver circuit 120 is connected to a signal output terminal of the airbag system 200, the airbag system 200 is configured to output a second type signal from the signal output terminal when detecting that the device in which the battery 400 is located undergoes a collision, and the driver circuit 120 is further configured to output, in response to receiving the second type signal, the drive signal to drive the safety module 420 to be disconnected.

The airbag system 200 may generate the second type signal when detecting that the device in which the control circuit 100 is located undergoes a collision. The second type signal may drive an airbag within the device to open. Generally, the second type signal is a PWM signal, and the driver circuit 120 can perform power amplification on the PWM signal to drive connection or disconnection of the safety module 420. There may be two input terminals of the driver circuit 120, one input terminal of which is connected to the signal output terminal of the airbag system 200, and the other input terminal of which is connected to the signal output terminal of the current detection unit 110. After receiving the first type signal or the second type signal, the driver circuit 120 can perform power amplification on the signal and then output the signal to the safety module 420, thereby driving the safety module 420 to be disconnected, and achieving a purpose of protecting other components in the target loop.

In the above-mentioned solution, the input terminal of the driver circuit 120 is directly connected to the signal output terminal of the airbag system 200, so that the driver circuit 120 can directly drive, after receiving the second type signal transmitted from the airbag system, the safety module 420 to be disconnected, thereby achieving a purpose of disconnecting the target loop. Compared with the current situation that a battery management module 500 needs to send a collision signal and then disconnect the target loop, this solution provides a higher speed of disconnecting the target loop.

In some embodiments, the airbag system 200 includes an airbag control unit 210 and an energy storage unit 220, the energy storage unit 220 is configured to provide power for the airbag control unit 210, and the airbag control unit 210 is configured to output the second type signal when detecting that a device in which the airbag control unit 210 is located undergoes a collision.

The airbag control unit 210, briefly referred to as ACU, is an electronic control module, which integrates an acceleration sensor unit that collects a vehicle acceleration signal. A main function of the ACU is to sample and analyze a driving state of a vehicle in real time. When the vehicle undergoes a collision accident, the ACU can detect the collision accident in a timely manner, and perform processing and algorithm analysis on severity of the collision to determine whether the airbag needs to be opened. If the airbag needs to be opened, the ACU controls the opening of the airbag to protect passengers in the vehicle, and records related data. The energy storage unit 220 may be any component capable of storing electric energy. The airbag control unit 210 may usually be provided with energy by the battery 400 or another energy storage apparatus on the device. However, when the battery 400 or the another energy storage apparatus is faulty or cannot provide energy due to other reasons, the energy storage unit 220 can be used as a backup energy supply apparatus to provide power for the airbag control unit 210.

In the above-mentioned solution, the energy storage unit 220 is disposed, so that the energy storage unit can be used for the airbag control unit 210, thereby improving reliability of generating the second type signal by the airbag control unit 210.

In some embodiments, the airbag system 200 includes an impedance detection unit 230 and a prompt unit 240. Two collection terminals of the impedance detection unit 230 are connected to a signal output terminal of the airbag control unit and the safety module 420, an output terminal of the impedance detection unit 230 is connected to the airbag control unit 210, and the impedance detection unit 230 is configured to send detected impedance between the signal output terminal of the airbag control unit 210 and the safety module 420 to the airbag control unit 210. An input terminal of the prompt unit 240 is connected to the airbag control unit 210, the airbag control unit 210 is configured to send prompt information to the prompt unit 240 in response to the impedance being greater than or equal to preset impedance, and the prompt unit 240 performs a preset prompt action after receiving the prompt information.

The impedance detection unit 230 may include an ADC collection module. Two collection terminals of the impedance collection unit are connected to the signal output terminal of the airbag control unit and the safety module 420, so that the impedance collection unit can detect the impedance between the signal output terminal and the safety module 420. If the impedance is large, the fourth type signal possibly cannot be transmitted to the safety module 420. In this case, a preset prompt action may be performed in advance through the prompt unit 240, and then impedance of a line between the signal output terminal and the safety module 420 can be reduced manually or by other means before the collision, so that the fourth type signal can be transmitted to the safety module 420 in a timely manner after the collision. The prompt unit 240 may include one or a plurality of a voice broadcast module, a light display module, and a communication module. For example, abnormality of the impedance of the line between the signal output terminal and the safety module 420 may be broadcast through a voice, or specific light may be displayed to prompt the abnormality, or prompt information may be sent to a preset receiver to prompt the abnormality.

In the above-mentioned solution, the impedance detection unit 230 and the prompt unit 240 are disposed in the airbag system 200, so that when it is detected that the second type signal possibly cannot be transmitted to the safety module 420 due to the large impedance between the signal output terminal of the airbag control unit and the safety module 420, the prompt information can be sent, which is convenient for a user to take a countermeasure in a timely manner, so that the fourth type signal can be transmitted to the safety module 420 when a transportation device in which the control circuit 100 is located undergoes a collision.

In some embodiments, the control system 10 includes a battery management module 500, one terminal of the battery management module 500 is connected to the battery 400, and an output terminal of the battery management module 500 is connected to the current detection unit 110 or the driver circuit 120.

Optionally, the input terminal of the driver circuit 120 is configured to connect to the battery management module 500 corresponding to the battery 400, the battery management module 500 is configured to input a fifth type signal to the driver circuit 120, and the driver circuit 120 outputs, when receiving the fifth type signal, a drive signal to drive the safety module 420 to be disconnected. The fifth type signal may also be a digital signal. For example, the battery management module 500 may send a preset fifth type signal when detecting that the target loop 410 needs to be disconnected, so that the driver circuit 120 can drive the target loop 410 to be disconnected. Optionally, another input terminal of the current detection unit 110 is configured to connect to the battery management module 500 corresponding to the battery 400, so as to send a fourth type signal after receiving the third type signal sent by the battery management module 500.

In the above-mentioned solution, a plurality of manners of driving the safety module 420 to be disconnected are provided, so that when some driving manners are problematic, the safety module 420 can still be driven to be disconnected.

In some embodiments, the target loop 410 is a power supply loop in the battery 400, the battery 400 is a battery pack, and the safety module 420 is an active safety. The safety module 420 may be a high-voltage switch that can be disconnected by the second type signal. In this solution, the second type signal sent by the airbag system 200 directly drives the safety module 420 in the battery pack. In addition, the airbag system 200 includes the energy storage unit 220 and the impedance detection unit 230. The energy storage unit 220 can provide a backup energy supply. The impedance detection unit 230 can detect the impedance between the signal output terminal of the airbag control unit 210 and the safety module 420, and determine whether the second type signal can arrive at the safety module 420. If the second type signal cannot arrive at the safety module, the user may be prompted by the prompt unit 240 to take a specific measure to reduce the impedance or increase the power of the second type signal, so that when a collision occurs subsequently, the second type signal can be transmitted to the safety module 420 to drive the safety module 420 to be disconnected, thereby achieving an effect of reliably disconnecting the safety module 420. The first type signal OC is coupled to the second type signal to disconnect the safety module 420, and the first type signal OC can separately disconnect the relay quickly. In addition, the first type signal OC may drive the loop of the safety module 420 by using the impedance detection function of the impedance detection unit 230, to ensure reliable disconnection. The driver circuit 120 and the supplementary driver circuit 130 may be optionally configured with the energy storage component 160 to avoid a failure of driving of the safety module 420 due to insufficient energy.

In this solution, the airbag system 200 directly drives the safety module 420 after detecting that the collision occurs. Compared with the original solution in which the safety module 420 is disconnected only after a CAN/hardware signal is transmitted to a BMS and then the BMS performs determining, this solution has lower costs and higher reliability in terms of battery safety with a collision sensor and parsing of a collision signal.

Because the safety module 420 may be driven in the case of both the collision and the overcurrent, and the airbag system 200 generally has a built-in loop impedance function, this design solution couples a collision driving function and an overcurrent/short circuit driving function to a control board, thereby ensuring that the high-voltage loop can still be reliably disconnected in the case of overcurrent and short circuit.

In some other embodiments, there are a plurality of target loops 410, and each target loop 410 corresponds to one driver circuit 120. For example, the target loop 410 may alternatively be a high-voltage loop, and the safety module 420 may be an active safety or any electrical switch with strong tensile arc resistance, such as a circuit breaker.

The current detection unit 110 may be a battery junction box, and the battery junction box may further receive a digital signal from the BMU/another controller and then drive the safety module 420 and the relay.

The control board is usually provided with energy by a V power supply of the entire vehicle. In this solution, an energy storage component 160 may be disposed in the control circuit 100, which can ensure that a high voltage can still be disconnected when the V power supply is abnormal.

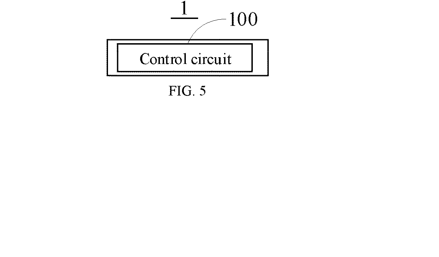

Referring to FIG. 5, as shown in FIG. 5, a transportation device 1 provided in this solution includes the control circuit 100 in any one of the above-mentioned embodiments.

In some other embodiments, the transportation device 1 may include the control system 10 described above.

The transportation device 1 provided in this embodiment may be an automobile, a battery cart, or another device whose specific loop needs to be disconnected in the case of a collision.

In the above-mentioned solution, the current detection unit is disposed in the control circuit of the present application, and the current detection unit can detect whether the battery cooperating with the current detection unit has an overcurrent or a short circuit, so as to output the first type signal and send the first type signal to the driver circuit. The driver circuit can disconnect a safety module in a first target loop after receiving the first type signal, thereby achieving an effect of disconnecting the first target loop when the battery is problematic.

In some embodiments, the functions of the apparatus provided in the embodiments of the present disclosure or the modules included therein may be used to perform the method described in the above-mentioned method embodiments. For a specific implementation thereof, reference may be made to the description of the above-mentioned method embodiments. For brevity, details are not described herein again.

The above-mentioned descriptions of the various embodiments tend to emphasize differences between the various embodiments. For same or similar parts thereof, mutual reference may be made to these embodiments. For brevity, details are not described herein again.

In several embodiments provided in the present application, it should be understood that the disclosed methods and apparatuses may be implemented in other ways. For example, the apparatus embodiments described above are merely illustrative. For example, the division into modules or units is merely a logical function division, and there may be other division manners in actual implementation. For example, units or components may be combined or may be integrated into another system, or some features may be ignored or not performed. For another image position, the mutual coupling or direct coupling or communication connection shown or discussed may be implemented through some interfaces, and the indirect coupling or communication connection between the apparatuses or units may be in an electrical, mechanical or another form.

In addition, various functional units in the various embodiments of the present application may be integrated into one processing unit, or various units may be physically present separately, or two or more units may be integrated into one unit. The above-mentioned integrated unit may be implemented in a form of hardware, or may be implemented in a form of a software functional unit. When the integrated unit is implemented in the form of a software functional unit and sold or used as an independent product, the integrated unit may be stored in a computer-readable storage medium. Based on such an understanding, the technical solutions of the present application essentially, or the part of the technical solutions that contributes to the prior art, or all or part of the technical solutions, may be embodied in the form of a software product, and the computer software product is stored in a storage medium and includes several instructions for causing a computer device (which may be a personal computer, a server, a network device, or the like) or a processor to perform all or part of the steps of the methods in the various embodiments of the present application. The above-mentioned storage medium includes various media that can store program code, such as a USB flash drive, a removable hard disk, a read-only memory (ROM), a random access memory (RAM), a magnetic disk, or an optical disc.

## Claims

1. A control circuit, configured to control connection or disconnection of a target loop after being connected to the target loop, and **characterized by** comprising:
a current detection unit, wherein the current detection unit is configured to: when being connected to a battery, output a first type signal when detecting that the battery has an overcurrent or a short circuit; and
a driver circuit, wherein an input terminal of the driver circuit is connected to a signal output terminal of the current detection unit, an output terminal of the driver circuit is configured to connect to a safety module in the target loop, and the driver circuit is configured to output, in response to receiving the first type signal transmitted from the current detection unit, a drive signal to drive the safety module to be disconnected,
wherein the target loop is a loop in the battery or a loop in a device in which the battery is located.

2. The control circuit according to claim 1, wherein
another input terminal of the driver circuit is connected to a signal output terminal of an airbag system, wherein the driver circuit is further configured to output, in response to receiving a second type signal transmitted from the airbag system, the drive signal to drive the safety module to be disconnected.

3. The control circuit according to claim 1, wherein
the control circuit further comprises a supplementary driver circuit, an input terminal of the supplementary driver circuit is connected to the signal output terminal of the current detection unit, an output terminal of the supplementary driver circuit is configured to connect to a switch component in the target loop, and the supplementary driver circuit is configured to drive, in response to receiving the first type signal, the switch component to be disconnected.

4. The control circuit according to claim 3, wherein
the switch component and the safety module are disposed on the same target loop, wherein the target loop comprises a power supply loop of the battery or a high-voltage loop of the device in which the battery is located; or
the switch component and the safety module are respectively disposed on different target loops, wherein the safety module is disposed on a first target loop, the switch component is disposed on a second target loop, the first target loop comprises the power supply loop of the battery, and the second target loop comprises the high-voltage loop of the device in which the battery is located; or the first target loop comprises the high-voltage loop of the device in which the battery is located, and the second target loop comprises the power supply loop of the battery.

5. The control circuit according to claim 3, wherein the switch component comprises a relay, two path terminals of the relay are separately connected to the target loop to cooperate with other components on the target loop to form the complete target loop, a control terminal of the relay is connected to the output terminal of the supplementary driver circuit, the control circuit further comprises a delay circuit, and the delay circuit is disposed between the current detection unit and the supplementary driver circuit, wherein by means of the delay circuit, a time at which the first type signal generated by the current detection unit arrives at the driver circuit is earlier than a time at which the first type signal arrives at the supplementary driver circuit.

6. The control circuit according to claim 1, wherein another input terminal of the current detection unit is configured to connect to a battery management module, and the current detection unit is configured to send a fourth type signal when receiving a third type signal sent by the battery management module, wherein the driver circuit is further configured to output, in response to receiving the fourth type signal, a drive signal to drive the safety module to be disconnected.

7. The control circuit according to any one of claims 1 to 6, wherein the control circuit further comprises a logic component, an input terminal of the logic component is connected to the signal output terminal of the current detection unit, an output terminal of the logic component is connected to the driver circuit, and the logic component is turned on when a signal output by the current detection unit is the first type signal.

8. The control circuit according to any one of claims 1 to 6, wherein the control circuit comprises an energy storage component, one terminal of the energy storage component charges the energy storage component when being connected to a power input apparatus, and the other terminal of the energy storage component is connected to the driver circuit and supplies power to the driver circuit.

9. The control circuit according to any one of claims 1 to 6, wherein an input terminal of the current detection unit is connected to a shunt in the battery, so that the current detection unit detects a current flowing through the shunt to determine whether the battery has an overcurrent or a short circuit.

10. The control circuit according to claim 9, wherein the current detection unit comprises a current collection circuit, a comparator, and a reference current output device;
a collection terminal of the current collection circuit is connected to the shunt; and
two input terminals of the comparator are respectively connected to an output terminal of the current collection circuit and an output terminal of the reference current output device, and the comparator outputs the first type signal when detecting that a current value output by the current collection circuit is greater than or equal to a reference current value output by the reference current output device.

11. The control circuit according to claim 1, wherein the output terminal of the driver circuit is further configured to connect to a relay in the target loop.

12. The control circuit according to any one of claims 1 to 6, wherein the input terminal of the driver circuit is configured to connect to the battery management module, the battery management module is configured to input a fifth type signal to the driver circuit, and the driver circuit outputs, when receiving the fifth type signal, a drive signal to drive the safety module to be disconnected.

13. The control circuit according to claim 1, wherein the driver circuit comprises a direct driver circuit, an isolation driver circuit, or a dedicated integrated driver chip.

14. The control circuit according to any one of claims 1 to 6, wherein the driver circuit comprises a gate resistor, a pull-down resistor, a logic level switching transistor, and a regulating resistor;
an input terminal of the gate resistor is connected to an output terminal of the current detection unit;
an input terminal of the pull-down resistor is connected to an output terminal of the gate resistor, and an output terminal of the pull-down resistor is grounded; and
a first terminal of the logic level switching transistor is connected to the output terminal of the gate resistor, a second terminal of the logic level switching transistor is grounded, a third terminal of the logic level switching transistor is connected to an input terminal of the regulating resistor, and an output terminal of the regulating resistor is connected to the safety module.

15. A control system, **characterized by** comprising:
a battery; and
the control circuit according to any one of claims 1 to 14, wherein the control circuit is configured to control connection or disconnection of a target loop after being connected to the target loop, and the control circuit comprises a current detection unit and a driver circuit;
the current detection unit is configured to: when being connected to the battery, output the first type signal when detecting that the battery has an overcurrent or a short circuit; and
an input terminal of the driver circuit is connected to a signal output terminal of the current detection unit, an output terminal of the driver circuit is configured to connect to a safety module in the target loop, and the driver circuit is configured to output, in response to receiving the first type signal transmitted from the current detection unit, a drive signal to drive the safety module to be disconnected,
wherein the target loop is a loop in the battery or a loop in a device in which the battery is located.

16. The control system according to claim 15, wherein the control system further comprises an airbag system, the input terminal of the driver circuit is connected to a signal output terminal of the airbag system, the airbag system is configured to output a second type signal from the signal output terminal when detecting that the device in which the battery is located undergoes a collision, and the driver circuit is further configured to output, in response to receiving the second type signal transmitted from the airbag system, the drive signal to drive the safety module to be disconnected.

17. The control system according to claim 16, wherein the airbag system comprises an airbag control unit and an energy storage unit, the energy storage unit is configured to provide power for the airbag control unit, and the airbag control unit is configured to output the second type signal when detecting that a device in which the airbag control unit is located undergoes a collision.

18. The control system according to claim 17, wherein the airbag system comprises an impedance detection unit and a prompt unit;
two collection terminals of the impedance detection unit are connected to a signal output terminal of the airbag control unit and the safety module, an output terminal of the impedance detection unit is connected to the airbag control unit, and the impedance detection unit is configured to send detected impedance between the signal output terminal of the airbag control unit and the safety module to the airbag control unit; and
an input terminal of the prompt unit is connected to the airbag control unit, the airbag control unit is configured to send prompt information to the prompt unit in response to the impedance being greater than or equal to preset impedance, and the prompt unit performs a preset prompt action after receiving the prompt information.

19. The control system according to any one of claims 15 to 18, wherein the control system comprises a battery management module, one terminal of the battery management module is connected to the battery, and an output terminal of the battery management module is connected to the current detection unit or the driver circuit.

20. A transportation device, **characterized by** comprising the control circuit according to any one of claims 1 to 14.
